# DEMANDE DE BREVET EUROPEEN

(11) **EP 0 672 909 A1**
(43) Date de publication de la demande: **20.09.1995**
(21) Numéro de dépôt: 95400564.1
(22) Date de dépôt: 15.03.1995
(51) Int. Cl.: G01R 31/04, G01R 31/02

(54) **Dispositif de contrôle pour connecteurs électriques**

(30) Priorité: 18.03.1994 FR 9403314
(71) Demandeur: SM CONTACT - SARL, F-77580 Crecy La Chapelle (FR)
(72) Inventeur: Berger, Jacques, F-77860 St Germain S/Morin (FR); Roshardt, Alain, F-77144 Chalifert (FR)
(74) Mandataire: Bonnetat, Christian

(57) **Abrégé**

Dispositif de contrôle (I) pour un connecteur électrique (13) à broches auxquelles sont reliées mécaniquement et électriquement les extrémités de conducteurs électriques (14), ledit dispositif comportant un organe de réception (2) pour ledit connecteur et des tiges de contact élastiques (17) parallèles entre elles, montées sur un organe mobile déplaçable en translation parallèlement aux axes desdites tiges de contact.

Selon l'invention, ce dispositif est caractérisé en ce que ledit organe mobile est un piston (5), se déplaçant dans un cylindre (4) pratiqué dans un bloc (1), sur lequel ledit organe de réception (2) est fixé, à l'aplomb dudit piston (5).

## Description

La présente invention a pour objet un dispositif de contrôle pour connecteurs électriques, permettant de tester, par exemple, des câbles, faisceaux et harnais électriques utilisés dans les industries automobile, aéronautique ou de l'électroménager.

On sait que de tels connecteurs électriques comportent des broches (mâle ou femelle) auxquelles sont électriquement reliées les extrémités des conducteurs électriques aboutissant auxdits connecteurs. L'objet d'un tel dispositif de contrôle est de vérifier qu'il y a contact électrique entre chacun desdits conducteurs et la broche qui lui correspond et/ou que chaque broche est bien solidarisée (par exemple par encliquetage) du connecteur auquel elle appartient.

On connaît déjà de nombreux dispositifs de contrôle de ce type, par exemple par GB-A-2 113 480, GB-A-2 086 670, GB-A-2 170 962, GB-A-2 270 427, GB-A-2 200 503, EP-A-0141305, EP-A-0354124, FR-A-2 592 174, DE-A-3 238 949, DE-A-3 340 064, DE-A-3 104 141, DE-A-2 748 590.

Dans les dispositifs de contrôle connus, on prévoit un organe de réception pour un connecteur et des tiges de contact élastiques, parallèles entre elles et connectées à un appareil électrique de contrôle. Ces tiges de contact sont montées sur un organe déplaçable en translation, parallèlement aux axes desdites tiges de contact, pour pouvoir prendre deux positions extrêmes, pour l'une desquel-les lesdites tiges de contact sont écartées desdites broches et pour l'autre desquelles les extrémités desdites tiges de contact sont en appui contre lesdites broches.

Les modes de réalisation pratiques de ces dispositifs de contrôle connus présentent des inconvénients :
- ils présentent des dimensions importantes, aussi bien en hauteur, en largeur qu'en épaisseur, de sorte qu'ils encombrent beaucoup le plan de travail sur lequel ils sont disposés et qu'ils rendent difficile la juxtaposition de plusieurs d'entre eux ; et
- ils sont constitués d'un grand nombre de pièces de base, de sorte que leurs coûts de fabrication et d'entretien sont élevés et que leur entretien est délicat, d'autant plus qu'un tel entretien nécessite généralement leur démontage.

La présente invention a pour objet de pallier ces inconvénients et elle concerne un dispositif de contrôle compact et de structure simple, ne comportant qu'un nombre très limité de pièces constitutives.

A cette fin, selon l'invention, le dispositif de contrôle pour un connecteur électrique comportant des broches qui sont rapportées au corps dudit connecteur et auxquelles sont reliées mécaniquement et électriquement les extrémités de conducteurs électriques devant être montés sur ledit connecteur, ledit dispositif de contrôle comportant un organe de réception pour ledit connecteur et des tiges de contact élastiques parallèles entre elles, connectées électriquement à un appareil électrique de contrôle et montées sur un organe mobile déplaçable en translation parallèlement aux axes desdites tiges de contact, pour pouvoir prendre deux positions extrêmes, l'une, de repos, pour laquelle lesdites tiges de contact sont écartées desdites broches et l'autre, de travail, pour laquelle les extrémités desdites tiges de contact sont en appui contre lesdites broches, est remarquable en ce que ledit organe mobile est un piston, se déplaçant dans un cylindre pratiqué dans un bloc, sur lequel ledit organe de réception est fixé, à l'aplomb dudit piston.

On voit qu'ainsi la structure du dispositif de contrôle est simple et que celui-ci peut être compact et ne comporter que trois pièces principales constitutives, à savoir ledit bloc, l'organe de réception et ledit piston.

Afin de faciliter les opérations d'entretien, de montage et de démontage, il est avantageux que, du côté opposé audit organe de réception dudit connecteur, ledit cylindre soit obturé par un bouchon amovible, rapporté de façon étanche audit bloc. Ainsi, ledit cylindre est facilement accessible de l'extérieur du dispositif, par simple démontage dudit bouchon amovible.

Avantageusement, ledit piston est mû par un fluide, par exemple de l'air comprimé, pénétrant et sortant dudit cylindre à travers ledit bouchon amovible.

Par ailleurs, afin de faciliter les liaisons électriques entre lesdites tiges de contact et ledit appareil électrique de contrôle, il est préférable :
- que ledit piston comporte un corps de piston creux, à section annulaire, ouvert en regard dudit bouchon amovible, mais obturé, du côté dudit organe de réception dudit connecteur, par une tête de piston traversée par lesdites tiges de contact, lesquelles sont solidaires de ladite tête de piston ;
- que ledit bouchon amovible comporte une tête permettant de le fixer sur ledit bloc et une cheminée annulaire, solidaire de ladite tête de bouchon et disposée à l'intérieur dudit corps de piston creux ; et
- qu'une liaison de coulissement étanche soit disposée entre ladite cheminée annulaire et ledit corps de piston.

Ainsi, lesdites tiges de contact et/ou lesdites liaisons électriques à l'appareil électrique de contrôle peuvent passer dans ledit bouchon amovible (par la cheminée annulaire) pour être accessibles de l'extérieur dudit dispositif de contrôle.

Il est évident que le dispositif de contrôle conforme à l'invention comporte, solidaires de son piston, autant de tiges de contact que le connecteur électrique comporte de broches et que la disposition desdites tiges de contact sur ledit piston correspond à la disposition desdites broches dans ledit connecteur, de façon que toutes les broches d'un connecteur puissent être testées simultanément lorsque ledit piston est dans la position extrême de travail.

Aussi, à cette fin, il est avantageux :
- que la section de la tête dudit piston soit suffisamment grande pour englober le contour extérieur de la disposition desdites broches sur ledit connecteur ; et
- que la forme de la section de la tête dudit piston corresponde au moins approximativement à la forme dudit contour extérieur des broches.

Par suite, si le connecteur comporte peu de broches, ou bien si lesdites broches sont disposées à l'intérieur d'un carré, d'un cercle ou d'un rectangle peu allongé, ledit piston peut avoir une section circulaire. En revanche, si lesdites broches sont disposées à l'intérieur d'un rectangle allongé ou analogue, ledit piston peut présenter une section allongée (par exemple ovale ou analogue) permettant de réduire ses dimensions transversalement à la longueur dudit rectangle (et donc l'encombrement transversal du dispositif).

De la description qui précède, on comprendra aisément que le dispositif de contrôle conforme à la présente invention est apte à contrôler aussi bien la continuité électrique entre broches et conducteurs que l'état de la liaison mécanique de solidarisation entre les broches et le connecteur.

Dans certains cas de test, seul le contrôle de la continuité électrique entre broches et conducteurs électriques est recherché. Il est alors possible de simplifier le mode opératoire en prévoyant de plus :
- un tampon, porteur de tiges de contact et susceptible d'être mis dans ledit cylindre à la place dudit piston ; et
- un bouchon auxiliaire, susceptible de remplacer ledit bouchon et de fixer ledit tampon en position à l'intérieur dudit cylindre.

Pour les mêmes raisons que celles mentionnées ci-dessus, ledit bouchon auxiliaire peut avantageusement comporter, tout comme ledit bouchon amovible, une tête permettant de le fixer sur ledit bloc et une cheminée annulaire solidaire de ladite tête et maintenant ledit tampon en position à l'intérieur du cylindre.

On remarquera que, dans le dispositif de contrôle conforme à la présente invention, on peut incorporer facilement dans ledit bloc et/ou dans ledit organe de réception un ou plusieurs verrous susceptibles de bloquer ledit connecteur dans ledit organe de réception.

Du fait de sa compacité, de son faible encombrement et de sa simplicité, le dispositif de contrôle conforme à la présente invention est facile à maintenir fermement pendant son utilisation. Par exemple, dans un mode de réalisation avantageux, le bloc dudit dispositif comporte, à cet effet, des moyens d'accrochage susceptibles de coopérer avec au moins un profilé, pour fixer de façon amovible ledit dispositif sur ledit profilé.

De tels moyens d'accrochage peuvent être réalisés de différentes façons. Cependant, dans un mode de réalisation avantageux, lesdits moyens d'accrochage sont formés par au moins une encoche pratiquée dans la paroi externe dudit bloc.

Lorsqu'il est ainsi accroché sur un ou plusieurs profilés, ledit dispositif de contrôle peut être disposé verticalement, ledit organe de réception étant de préférence dirigé vers le haut. Toutefois, il peut être avantageux que lesdits moyens d'accrochage coopèrent avec ledit ou lesdits profilés, de façon que ledit dispositif de contrôle soit incliné par rapport à la verticale. Une telle disposition inclinée est particulièrement favorable dans le cas d'un contrôle d'encliquetage des broches dans des connecteurs ; en effet, les fils reliant deux connecteurs ne sont alors pas contraints de faire un angle aigu avec l'axe desdits connecteurs. On remarquera de plus qu'une telle disposition inclinée permet d'effectuer un contrôle des longueurs de câble reliant deux ou plusieurs connecteurs. En effet, les dispositifs concernés peuvent alors être inclinés l'un vers l'autre et placés à une distance telle que ledit câble soit tendu quand les connecteurs sont disposés dans leurs organes de réception réceptifs.

Une telle disposition inclinée n'est possible que parce que les dispositifs selon l'invention sont compacts ; elle ne peut être obtenue avec les dispositifs encombrants connus, sauf à réduire leur nombre sur un plan de travail ou à augmenter exagérément les dimensions d'un tel plan de travail.

De ce qui précède, on comprend aisément qu'il est avantageux qu'un plan de travail pour le dispositif conforme à la présente invention comporte une pluralité de profilés disposés parallèlement les uns aux autres et que, de plus, lesdits moyens d'accrochage permettent le coulissement desdits dispositifs de contrôle le long desdits profilés. Ainsi, on peut effectuer un contrôle de longueur de câbles entre connecteurs d'un faisceau électrique, par coulissement de ceux-ci le long des profilés, sans contrainte de positionnement.

De préférence, lesdits profilés du plan de travail présentent une section en U, l'accrochage de chacun desdits dispositifs de contrôle s'effectuant sur l'une des arêtes libres d'au moins l'un desdits profilés.

Les figures du dessin annexé feront bien comprendre comment l'invention peut être réalisée. Sur ces figures des références identiques décrivent des éléments semblables.

La figure 1 est une vue en coupe verticale d'un exemple de réalisation du dispositif de contrôle conforme à la présente invention.

La figure 2 est une vue de dessus du dispositif de contrôle de la figure 1.

Les figures 3 et 4 sont des vues en coupe verticale de variantes de réalisation du dispositif de contrôle conforme à la présente invention, disposées de façon inclinée par rapport à la verticale.

La figure 5 est une vue de dessus du dispositif de la figure 4, selon l'axe d'inclinaison de celui-ci.

La figure 6 montre, en coupe verticale, un exemple simplifié du dispositif de contrôle conforme à la présente invention.

La figure 7 illustre plusieurs dispositions différentes de dispositifs conformes à l'invention, sur un plan de travail constitué de profilés parallèles.

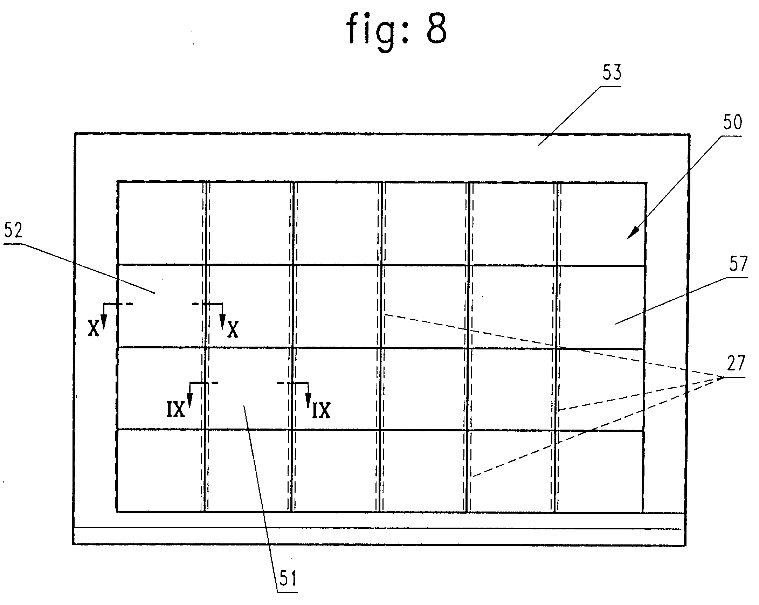

La figure 8 est une vue de dessus du plan de travail de la figure 7, obturée par des plaques de recouvrement.

Les figures 9 et 10 sont des coupes transversales, respectivement selon les lignes de coupe IX-IX et X-X de la figure 8.

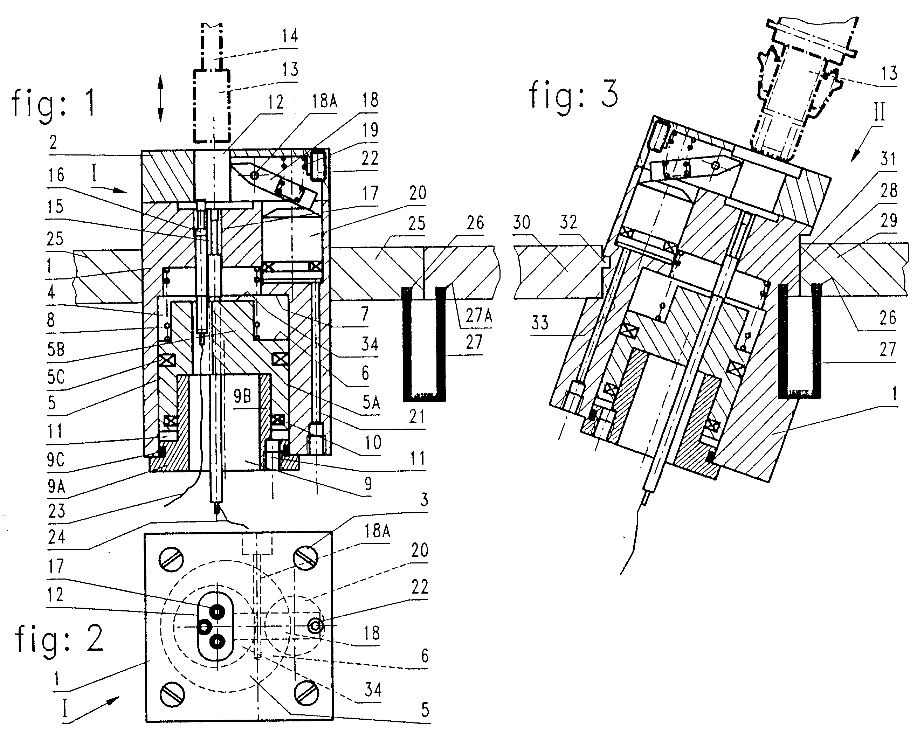

L'exemple de réalisation I du dispositif de contrôle conforme à l'invention, montré par les figures 1 et 2, comporte un bloc 1 sur lequel est monté un organe de réception 2, fixé audit bloc 1 par exemple par des vis 3.

A l'intérieur du bloc 1 est usiné un cylindre 4 dans lequel peut se déplacer un piston 5. Ce piston 5 comporte un corps de piston creux 5A, à section annulaire, ouvert du côté opposé à l'organe de réception 2, mais obturé, du côté de ce dernier organe, par une tête de piston 5B. Entre le corps de piston 5A et la tête de piston 5B est formé un épaulement 6 pouvant coopérer avec un épaulement correspondant 7 du cylindre, afin de limiter la course de ce piston. Au moins un joint 5C assure l'étanchéité entre le corps 5A et le cylindre 4.

Le piston 5 est chargé par un ressort 8 tendant à le repousser en direction opposée à l'organe de réception 2.

Du côté opposé audit organe de réception 2, le cylindre 4 est fermé par un bouchon amovible 9 comportant une tête 9A, susceptible d'être fixée à la base du bloc 1, par exemple, par des vis semblables aux vis 3, et une cheminée tubulaire 9B pénétrant à l'intérieur du corps de piston creux 5A pour que celui-ci puisse y coulisser de manière étanche grâce à au moins un joint 10. La cheminée tubulaire 9B sert de butée au piston 5 lorsque celui-ci est en position de repos, c'est-à-dire celle représentée sur la figure 1 dans laquelle le piston 5 est en appui contre le bouchon 9 sous l'action du ressort 8. Au moins un joint 9C assure l'étanchéité entre le cylindre 4 et le bouchon 9.

Des moyens d'alimentation 11, traversant le bouchon 9, sont susceptibles d'alimenter en fluide sous pression, par exemple de l'air comprimé, la chambre annulaire 11 se trouvant entre ledit bouchon 9, le cylindre 4 et le piston 5.

Dans l'organe de réception 2 est pratiquée l'empreinte 12 d'un connecteur 13 relié à un câble 14. Les différents conducteurs formant le câble 14 sont reliés à une broche (non représentée) encliquetée dans le connecteur 13.

Le cylindre 4 communique avec la base de l'empreinte 12 par un conduit 15 dans lequel sont disposées d'une part, une tige de contact fixe 16 et, d'autre part, des tiges de contact élastiques 17, solidaires en déplacement de la tête de piston 5B. Par ailleurs, dans le bloc 1 et dans l'organe de réception 2 est agencé un verrou susceptible de verrouiller ledit connecteur 13 dans l'empreinte 12 et comportant un cliquet 18, chargé par un ressort 19 et susceptible de pivoter, autour d'un axe 18A sous l'action d'un piston 20 logé dans le bloc 1 et alimenté en fluide par l'intermédiaire d'une conduite d'alimentation 21.

Par ailleurs, une vis 22 permet de régler la course du cliquet 18. Ainsi, lorsque l'on introduit le connecteur électrique 13 dans l'empreinte 12, il est possible de verrouiller ledit connecteur en position grâce à l'action du cliquet et du piston 20.

La présence du connecteur 13 dans l'empreinte 12 est détectée par la tige de contact fixe 16, qui en avertit un appareil électrique de contrôle (non représenté) par l'intermédiaire du conducteur 23.

Ledit appareil électrique actionne le piston 5 en lui adressant de l'air comprimé, à travers l'alimentation 11, de sorte que le piston 5 se déplace en direction de l'organe de réception 2, à l'encontre de l'action du ressort 8.

Dans ce mouvement ascendant du piston 5, les tiges de contact 17 sont amenées en appui contre les broches (non représentées) du connecteur 13, reliées aux conducteurs du câble 14.

Les tiges de contact 17 étant reliées par des conducteurs 24 audit appareil électrique de contrôle, celui peut déterminer, d'une part, si lesdites broches sont correctement encliquetées dans le connecteur 13 et s'il existe un contact électrique satisfaisant entre chacune de ces broches et le conducteur du câble 14 qui y est relié.

Après le test du connecteur 13, l'alimentation 11 est mise à l'échappement et le ressort 8 repousse le piston 5 (et donc les tiges élastiques 17) dans la position initiale représentée sur la figure 1.

Par ailleurs, comme on peut le voir sur la figure 1, le bloc 1 est pourvu d'ailes latérales 25 comportant des encoches 26 susceptibles de venir s'accrocher sur l'une des arêtes 27A de profilés 27 à section en U, pour supporter le dispositif conforme à la présente invention.

Dans l'exemple de réalisation II, illustré en coupe sur la figure 3, on retrouve la plupart des éléments décrits à propos des figures 1 et 2.

Cependant, dans ce cas, ce dispositif de contrôle II est prévu pour un type de connecteur 13 différent de celui de la figure 1.

De plus, le bloc 1 comporte des encoches 28 susceptibles de lui permettre de s'accrocher directement sur les arêtes des profilés 27.

Des plaques 29 et 30 sont susceptibles de coopérer avec le dispositif de contrôle II pour obturer les espaces entre deux profilés 27 consécutifs.

Par exemple, la plaque 29 est pourvue d'une encoche 26 susceptible de s'accrocher sur une arête libre d'un profilé 27 et de s'appuyer, en bout, contre une face 31 du bloc 1.

En revanche, la plaque 30 comporte dans son chant, une nervure 32 susceptible de coopérer avec une rainure de forme correspondante prévue dans ledit bloc 1.

Là encore, le bloc 1 comporte une face 33 contre laquelle vient en appui une partie du chant de la plaque 30, non pourvu de rainure 32.

On comprendra aisément que les dispositifs I et II peuvent être coulissés sur des profilés 27, pour qu'ils puissent y prendre toute position désirée.

Comme on peut le voir sur les figures 1 et 2, la surface supérieure 34 de la tête de piston 5B est circulaire et engloble le fond de l'empreinte 12, afin que chacune des tiges de contact 17 puisse se trouver en regard d'une des broches du connecteur 13.

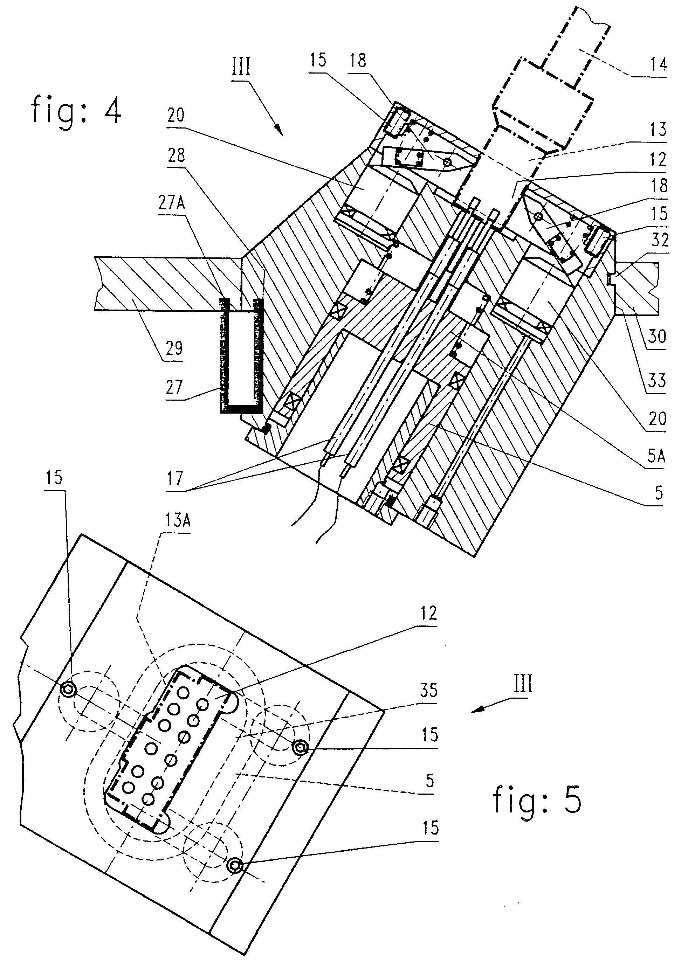

Dans l'exemple de réalisation III, montré par les figures 4 et 5, on retrouve également la plupart des éléments décrits ci-dessus.

On peut cependant y voir que l'on a prévu plusieurs dispositifs de verrouillage à cliquet 18 et piston 20. Ces dispositifs de verrouillage sont répartis à la périphérie de l'empreinte 12.

Par ailleurs, on remarquera que dans ce cas, le connecteur 13 testé comporte une pluralité de broches réparties selon un contour 13A au moins approximativement rectangulaire.

Afin de permettre de tester toutes les broches sans que le piston 5 occupe un encombrement excessif, on prévoit que la tête 5A de celui-ci présente une forme 35 oblongue, ovale ou analogue.

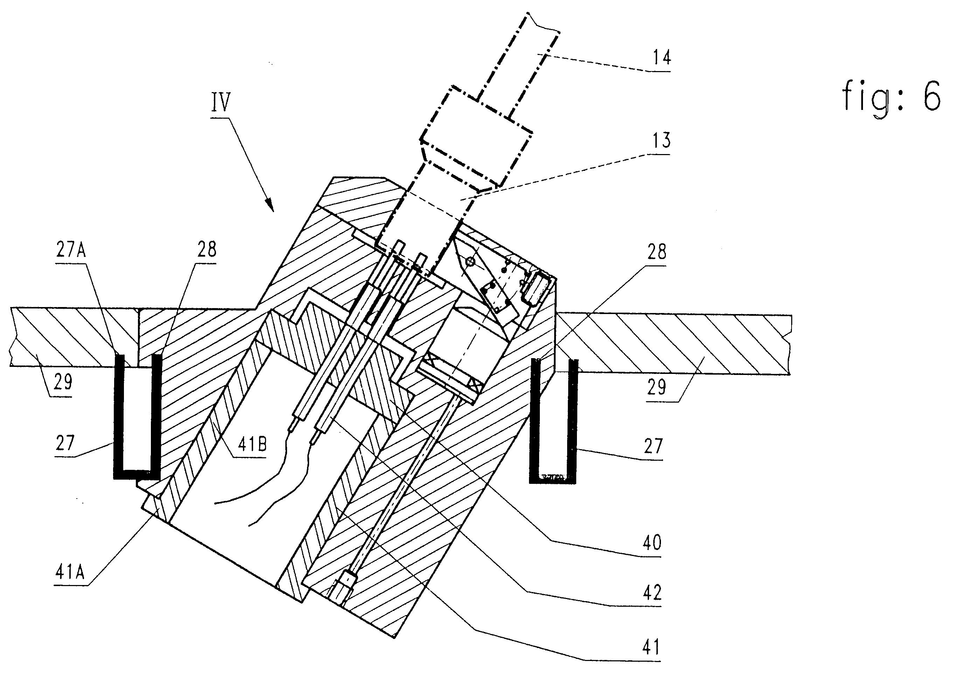

Dans l'exemple de réalisation IV, montré par la figure 6, on a remplacé le piston 5 par un simple tampon fixe 40, bloqué en position par un bouchon fixe. Le tampon 40 porte des tiges de contact 42, tandis que le bouchon 41 comporte une tête 41A (comparable à la tête 9A) et une cheminée annulaire 41B (comparable à la cheminée 9B), solidaire de la tête 41A et maintenant le tampon 40 en position.

Bien entendu, dans ce cas, seul les tests de conductibilité électriques sont possibles.

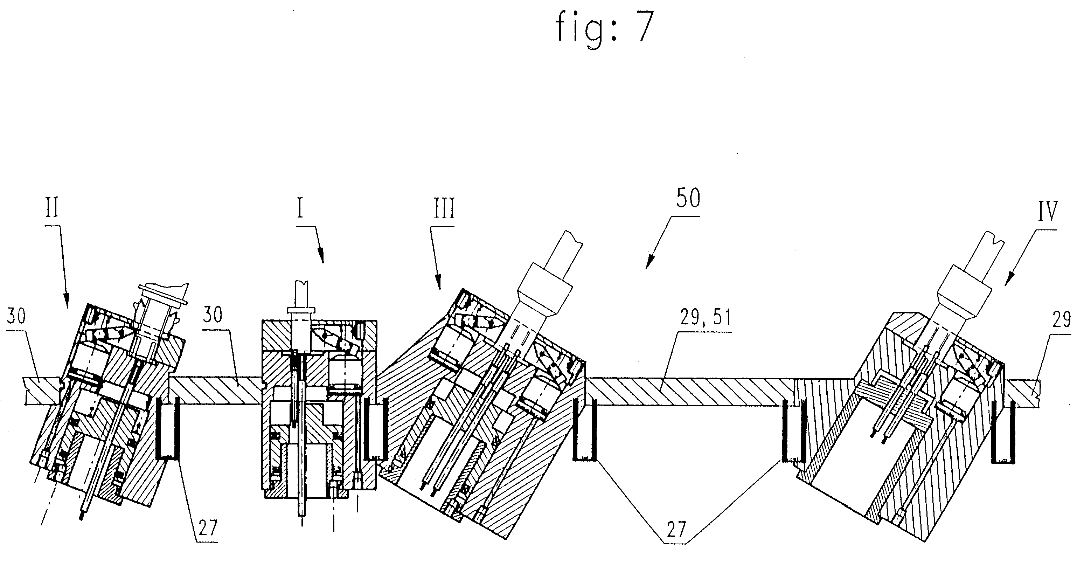

La figure 7 a simplement pour objet de représenter quelques types de dispositifs de contrôle I à IV conformes à la présente invention, respectivement accrochés à une pluralité de profilés de support 27, parallèles les uns aux autres.

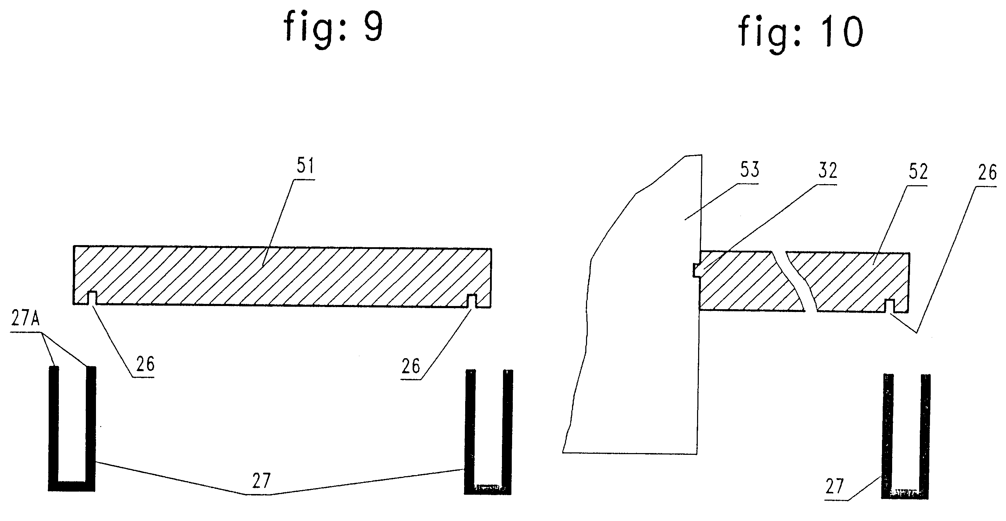

Ces profilés de support 27 forment un plan de travail 50 qui est délimité par un cadre 53 et qui, lorsqu'aucun dispositif de contrôle est en test peut être obturé par des plaques 51 ou 52 (par exemple semblables aux plaques 29 et 30), comme cela est plus précisément représenté en coupe sur les figures 9 et 10.

## Revendications

1. Dispositif de contrôle (I,II, III, IV) pour un connecteur électrique (13) comportant des broches qui sont rapportées au corps dudit connecteur et auxquelles sont reliées mécaniquement et électriquement les extrémités de conducteurs électriques (14) devant être montés sur ledit connecteur, ledit dispositif de contrôle comportant un organe de réception (2) pour ledit connecteur et des tiges de contact élastiques (17) parallèles entre elles, connectées électriquement à un appareil électrique de contrôle et montées sur un organe mobile déplaçable en translation parallèlement aux axes desdites tiges de contact, pour pouvoir prendre deux positions extrêmes, l'une, de repos, pour laquelle lesdites tiges de contact sont écartées desdites broches et l'autre, de travail, pour laquelle les extrémités desdites tiges de contact sont en appui contre lesdites broches,
caractérisé en ce que ledit organe mobile est un piston (5), se déplaçant dans un cylindre (4) pratiqué dans un bloc (1), sur lequel ledit organe de réception (2) est fixé, à l'aplomb dudit piston (5).

2. Dispositif selon la revendication 1,
caractérisé en ce que, du côté opposé audit organe de réception (2) dudit connecteur (13), ledit cylindre (4) est obturé par un bouchon amovible (9), rapporté de façon étanche audit bloc (1).

3. Dispositif selon la revendication 2,
caractérisé en ce que ledit piston (5) est mû par un fluide, pénétrant et sortant dudit cylindre (en 11) à travers ledit bouchon amovible (9).

4. Dispositif selon la revendication 2,
caractérisé en ce que :
- ledit piston (5) comporte un corps de piston creux (5A), à section annulaire, ouvert en regard dudit bouchon amovible, mais obturé, du côté dudit organe de réception (2) dudit connecteur (13), par une tête de piston (5B) traversée par lesdites tiges de contact (7), lesquelles sont solidaires de ladite tête de piston ;
- ledit bouchon amovible (9) comporte une tête (9A) permettant de le fixer sur ledit bloc (1) et une cheminée annulaire (9B), solidaire de ladite tête de bouchon et disposée à l'intérieur dudit corps de piston creux (5) ; et
- une liaison de coulissement étanche (10) est disposée entre ladite cheminée annulaire (9B) et ledit corps de piston (5A).

5. Dispositif selon la revendication 4,
caractérisé en ce que la section de la tête (5B) dudit piston est suffisamment grande pour englober le contour extérieur de la disposition desdites broches sur ledit connecteur.

6. Dispositif selon la revendication 5,
caractérisé en ce que la forme de la section de la tête (5B) dudit piston correspond au moins approximativement à la forme dudit contour extérieur.

7. Dispositif selon l'une quelconque des revendications 2 à 6,
caractérisé en ce qu'il comporte de plus :
- un tampon (40), porteur de tiges de contact et susceptible d'être mis dans ledit cylindre (4) à la place dudit piston (5) ; et
- un bouchon auxiliaire (41), susceptible de remplacer ledit bouchon et de fixer ledit tampon (40) en position à l'intérieur dudit cylindre (4).

8. Dispositif selon les revendications 3 et 7,
caractérisé en ce que ledit bouchon auxiliaire (41) comporte, tout comme ledit bouchon amovible (9), une tête (41A) permettant de le fixer sur ledit bloc et une cheminée annulaire (41B) solidaire de ladite tête et maintenant ledit tampon (40) en position.

9. Dispositif selon l'une des revendications 3 à 8,
caractérisé en ce que ledit bloc (1) comporte des moyens d'accrochage (25, 28) susceptibles de coopérer avec au moins un profilé (27), pour fixer de façon amovible ledit dispositif sur ledit profilé.

10. Dispositif selon la revendication 9,
caractérisé en ce que lesdits moyens d'accrochage sont formés par au moins une encoche (28) pratiquée dans la paroi externe dudit bloc (1).

11. Dispositif selon l'une des revendications 9 ou 10,
caractérisé en ce que lesdits moyens d'accrochage (25,28) coopèrent avec ledit ou lesdits profilés (27) de façon que ledit dispositif de contrôle soit incliné par rapport à la verticale.

12. Plan de travail pour au moins un dispositif de contrôle tel que spécifié sous l'une quelconque des revendications 9 à 10,
caractérisé en ce qu'il comporte une pluralité de tels profilés (27), disposés parallèlement les uns aux autres.

13. Plan de travail selon la revendication 12,
caractérisé en ce que lesdits moyens d'accrochage (25,28) permettent le coulissement desdits dispositifs de contrôle le long desdits profilés (27).

14. Plan de travail selon l'une quelconque des revendications 12 ou 13,
caractérisé en ce que lesdits profilés (27) présentent une section en U, l'accrochage de chacun desdits dispositifs s'effectuant sur l'une des arêtes libres (27A) d'au moins l'un desdits profilés (27).
